Europäisches Patentamt

European Patent Office

Office européen des brevets

(11) Publication number: **0 453 675 A1**

## EUROPEAN PATENT APPLICATION

(21) Application number: 90304593.8

(22) Date of filing: 27.04.90

(51) Int. Cl.⁵: **H05K 7/20**, H01L 23/427, H01L 23/44

(43) Date of publication of application:
30.10.91 Bulletin 91/44

(84) Designated Contracting States:
BE CH DE FR GB IT LI LU NL

(71) Applicant: **DIGITAL EQUIPMENT CORPORATION**
111 Powdermill Road
Maynard Massachusetts 01754-1418(US)

(72) Inventor: **Griffith, James L.**
64 Crestview Drive
Holden, Massachusetts 01520(US)

(74) Representative: **Maggs, Michael Norman et al**
Kilburn & Strode 30 John Street
GB-London WC1N 2DD(GB)

(54) Independent cooling chamber for multichip unit.

(57) An independent cooling chamber for multichip units includes a housing defining a first chamber. The housing is secured to a multichip unit over at least one semiconductor chip that is a part of the multichip unit. An interface between the housing and the multichip unit includes a seal providing a fluid tight seal between the sides of the housing and the multichip unit, thus defining a first fluid tight chamber within which one or more semiconductor chips are located. A first coolant is provided in the first fluid tight chamber. The first coolant is in heat transfer relationship with the semiconductor chips located in the first fluid tight chamber. The housing includes a heat exchanger including a second chamber in heat transfer relationship with the first chamber. A second coolant is contained within the second chamber for transfer of heat from the first coolant.

FIG.1

Rank Xerox (UK) Business Services

The device of the present invention generally relates to a new and improved system for cooling a component of a multicomponent device and to a new and improved method for cooling such a component; and more particularly, to a new and improved independent cooling chamber for multichip units and a method for cooling semiconductor chips in multichip units.

Current high performance integrated circuit chips not only contain a large number of semiconductor transistors and switches, but operate at speeds higher than experienced in the past. Such chips must, at times, produce millions of "0 to 1" or "1 to 0" transitions each second. By doing significantly more work in a shorter space of time, each semiconductor chip requires more operating power. Higher operating power means higher heat levels are generated, and if the generated heat is not dissipated, the semiconductor chips will fail. Consequently, cooling is an important consideration when designing computer circuits. Without sufficient cooling, clock rates must be reduced which means slower computer operating speeds, and this is opposite the goal sought by the designers of high speed computers.

An objective in using semiconductor or microchips is that they interact successfully with one another in complex, high density computer environments. If this goal is to be achieved, system speeds must approach closely the individual chip speeds. If these speeds cannot be obtained, the advantages of high-performance chips will not be realized and fully exploited. To obtain the full or high-performance capabilities of microchips, interacting signals must reach destinations at local or distant microchips with minimal time-phase errors. Time-phase errors are a function of the time it takes electronic signals to move along a conductor. The longer the conductor, the longer the time it takes a signal to reach its destination. Thus, if each of several receiving circuits is at a significantly different distance from a common transmitting circuit, the timing of the individual operations of the circuit could be affected.

One way to reduce the distance between chips is to move the chips closer. A design disadvantage in moving chips closer, however, is that although packing many chips on the same multichip unit ("MCU") reduces interconnector links, chips operating in such crowded environments tend to overheat more rapidly which can result in failure of the chip unless an adequate cooling system is provided. Adequate cooling requires extracting heat away from the chips at least as rapidly as the heat is generated.

One form of cooling that has been tried involves putting heat extraction devices into contact with selected semiconductor chips to extract heat from the chips and keep them at operating temperatures. Since input/output electrical conductors also touch the semiconductor chips, bringing heat extracting devices into contact with each chip causes the region in the immediate vicinity of these chips to become very crowded. In a crowded chip environment heat builds up more rapidly and is harder to dissipate.

Two other types of cooling are bottom side cooling and top side cooling which refer to the direction heat takes when exiting the heated chip. An example of bottom side cooling is an arrangement in which semiconductor chips are bonded to a molybdenum bottom plate. The bottom plate and several layers of conductors with which it is associated form a multiplane or high density signal carrier. The plate provides a cooling function by conducting heat away from chips bonded to it. This cooling procedure requires direct contact of the bottom of the chips with the plate. To obtain this contact the high density signal carrier and all associated conductor layers must be penetrated or opened to allow contact between the chip and the plate. These penetrations create a design problem since the space taken by the chips cannot be occupied by conductors in those several layers that have been penetrated. As a result, the conductors running between the different plates and layers must be rerouted to clear the penetrations thus increasing the conductor length and reducing the performance of the chips.

In place of bottom side cooling, top side cooling may be used. Top side cooling typically involves contact of conducting material (either mechanical or fluid) directly on the top of one or more of the heated chip surfaces thereby carrying away the heat developed in the chip. Top side cooling has the advantage of freeing up space in the conductor layers in the multichip unit thereby optimizing the lengths of the conductors needed.

A top side mechanical cooling system typically employs thermal conductors mechanically in contact with a chip to absorb unwanted heat and transport it towards a cooler end of the mechanical thermal conductor. The cooler end of the conductor usually contacts another heat absorber which takes on and absorbs the unwanted heat.

There are also liquid top side cooling systems that allow fluids to flow into contact with heated surfaces. Heat is transferred to the fluids which, in turn, expand. This expansion reduces the density of the fluid and the hotter liquids are free to move upward away from the heat source, in this case a semiconductor chip. One form of top side cooling using a liquid employs a large, centralized shared cooling chamber. Using this cooling system, several circuit boards are positioned within a large common cooling chamber. The circuit boards in this system are immersed in the coolant liquid exposing both sides of each multichip unit package board to the coolant.

The centralized liquid cooling system requires expensive and time consuming maintenance. To maintain or service individual boards, the entire system must be shut down and the technician must remove the board to be serviced from the cooling chamber. This servicing procedure requires the technician to handle the coolant. The coolants are often expensive and some may be toxic such that special care is required to avoid dripping and spilling of the liquid during the servicing. On-site testing of this cooling system is also very difficult since the chips must be cooled while they are being tested. To test the individual chips and chip boards while maintaining the cooling system in an inoperative state requires specialized equipment not readily available to field maintenance personnel. This requirement for specialized equipment increases the cost for servicing due to the additional training of technicians in this critically important procedure prone operation.

It is desirable to provide an independent coolant chamber that is a part of each multichip unit. Such a system would be more convenient to manufacture and service, and would require significantly less coolant reducing the cost for the total volume of coolant required.

An objective of the present invention is to provide a new and improved device for extracting heat from multichip units. Another objective of the present invention is to provide a new and improved method for cooling semiconductor chips or microchips.

A further object of the present invention is to provide a new and improved portable, independent cooling chamber for multichip units for extracting heat from semiconductor chips in the multichip unit.

A still further object of the present invention is to provide a new and improved method for independently cooling multichip units and the semiconductor chips included in those multichip units.

Briefly, the present invention is directed to a new and improved independent cooling chamber for multichip units for cooling semiconductor chips, and to a new and improved method for cooling semiconductor chips in a multichip unit. The independent cooling chamber of the present invention includes a housing that is secured to a circuit board on which semiconductor chips are mounted. A seal is provided to seal the interface between the housing and the circuit board, thereby providing a first, fluid tight chamber within the housing.

Semiconductor chips mounted on the circuit board are located within the first chamber defined by the housing. A first coolant, either a fluid or gas, is introduced into the first chamber. During operation of the semiconductor chips, heat is transferred from the surface of the semiconductor chips to the first coolant. If desired, a second chamber can be provided on the housing in heat transfer relationship with the first chamber. A second coolant is provided in the second chamber, and heat in the first coolant is transferred to the second coolant.

In accordance with the principles of the present invention, a separate cooling chamber can be provided for each multichip unit. This arrangement of independent cooling chambers provides a portable unit that is easily serviced and assembled significantly reducing the cost of the over-all systems. Due to the greater cooling effect of the independent cooling chambers of the present invention, higher chip densities on multichip units than previously available in the prior art can be obtained. Higher density allows computer designers to exploit the advantages of shorter interconnections and to improve time-phase relationships between transmitting and receiving chip circuits.

Other objects and advantages of the invention will become apparent upon reading the following detailed description and upon reference to the drawings in which:

FIG. 1 is an exploded, perspective view of an independent cooling chamber and a multichip unit constructed in accordance with the principles of the present invention; and

FIG. 2 is a partially cut-away, side view of the independent cooling chamber and multichip unit of the present invention.

While the invention is susceptible to various modifications and alternative forms, specific embodiments thereof have been shown by way of example in the drawings and will herein be described in detail. It should be understood, however, that it is not intended to limit the invention to the particular forms disclosed, but on the contrary, the intention is to cover all modifications, equivalents, and alternatives falling within the spirit and scope of the invention as defined by the appended claims.

Microchips or semiconductor chips for computers and similar electronic devices are typically mounted on a circuit board or multichip unit. The multichip unit functions to protect the chips from the environment and heat, and also supports the needs of the chips for power and signal interconnections between other chips within the multichip unit and other multichip units within the computer or electronic device. Advances in electronics, including computer design, have been toward increasing the speed at which semiconductor chips operate thereby increasing the amount of work the chips perform. Higher speeds mean higher operating power resulting in higher operating heat levels.

These higher operating heat levels have caused a design problem. To increase the operating speeds of chips, designers have increased the density of chips on multichip units or circuit boards. Increased density of the chips combined with higher operating heat levels, however, results in overheating of the chips causing breakdown and eventual destruction.

The response to the overheating problem has been to cool the chips in some way. cooling chips mounted on a multichip unit is difficult due to the density of the chips and the need for the cooling system not to obstruct interchip conductors. In addition, it is necessary to minimize expense and maintenance of the cooling system. For these reasons, the cooling system is preferably self-contained, requires a minimum amount of coolant, and allows testing of the chips without shutting down the entire cooling system. An independent cooling system capable of cooling a specific group of chips, such as, for example, only the chips on a single multichip unit, can satisfy these design parameters. By having an independent cooling system, each multichip unit in a computer or other electronic device can be cooled, maintained, tested and replaced separately of other multichip units.

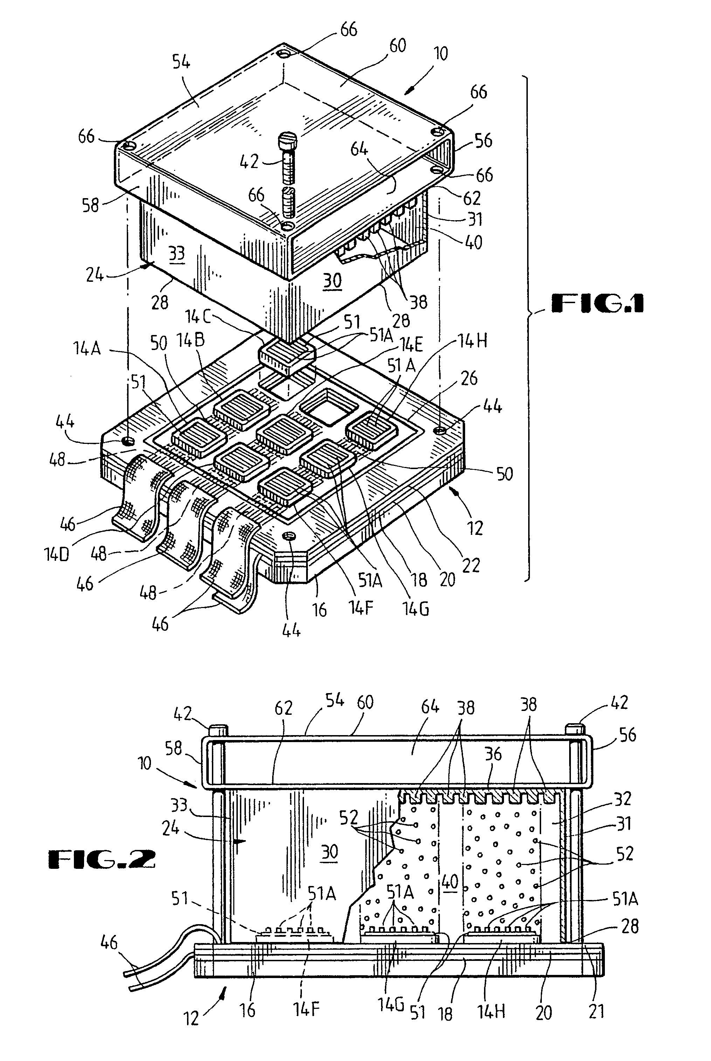

An independent cooling system for multichip units is illustrated in FIGS. 1 and 2, and is generally designated by the reference numeral 10. The cooling system 10 is independent in the sense that it is a part of a multichip unit generally designated by the reference numeral 12, and is specifically intended to cool only those semiconductor chips or microchips 14A, 140, 14C, 14D, 14E, 14F, 14G and 14H mounted on the multichip unit 12.

The multichip unit 12 is a coolant-impervious, high-density, multiplane circuit board including a base plate 16, a power plane 18, a signal plane 20, and a high-density signal carrier 22. The high-density signal carrier 22 supports the high-performance chips 14A, 14B, 14C, 14D, 14E, 14F, 14G and 14H which are secured to the carrier 22 by a Tape Automated Bonding technique or similar technique.

It is the purpose of the independent cooling system 10 to cool the chips 14A-H on the multichip unit 12 while minimizing the surfaces other than the chips that are cooled. This requires that the cooling system 10 not extend beyond that portion of the carrier 22 supporting the chips 14A-H. It is also necessary that the cooling system 10 be portable to allow testing and repair or replacement of the chips 14A-H. Each of these requirements is satisfied by a housing 24 that is secured to the multichip unit 12 to mate precisely with a sealing track 26 formed in the upper surface of signal carrier 22 near the outer periphery. The sealing track 26 includes a seal that seals the interface between the lower edge 28 of the housing 24 and the upper surface of the signal carrier 22. The lower edge 28 of the housing 24 is defined by the lower ends of four walls, 30, 31, 32 and 34 of the housing 24.

In addition to the four walls, 30, 31, 32, and 34, the housing 24 includes a top 36 having downwardly projecting fins 38. The walls 30, 31, 32, and 34, and the top 36 of the housing 24 define a chamber 40 that is fluid and gas tight once the housing 24 is secured onto the multichip unit 12 with the lower 28 sealingly engaging the sealing track 26. The housing 24 is securely fastened to the multichip unit 12 by fasteners 42. The fasteners 42 are anchored or screwed into threaded apertures 44 formed in the multichip unit 12, and are secured to the independent cooling system 10 in a manner described in the following paragraphs.

A requirement of the independent cooling system 10 is to avoid interference with the flat cables 46 external to the multichip unit 12 and the internal conductor paths 48 which interconnect the chips 14A-H within the multichip unit 12. The internal conductor paths 48 run from the chips 14A-H downward or inwardly to the interior of the multichip unit 12 to the signal plane 20. From the signal plane 20, the conductor paths 48 run under the sealing track 26 to the flat cables 46 through which data can reach other destinations within or external to the multichip unit 12. Data addressed to other chips within the multichip unit 12 follow other internal conductors 50. The path of the conductors 48 passes under the sealing track 26 and the housing 24 does not interfere with the conductors 48. Since conductors 50 are internal, there is no interference with these conductors by the independent cooling system 10.

Cooling of the chips 14A-H is accomplished by a coolant in the chamber 40. The coolant may be fluid, such as air, and in a preferred embodiment, the coolant is a fluorocarbon. The chips 14A-H are cooled by an extended surface on each chip 14A-H that, in the preferred embodiment, is a cooper sheet 51 soldered to the back of each chip 14A-H. Each cooper sheet 51 includes fins 51A extending into the coolant in the chamber 40. Heat is transferred from the chips 14A-H to the cooper sheet 51, and from the cooper sheet 51 to the fins 51A. Cooling is then accomplished through discontinuous cooling. In discontinuous cooling, the coolant is in a liquid state when the chamber 40 is at operating ambient temperature. As the temperature of the coolant increases, as by an increase in the operating temperature of the chips, the coolant undergoes a change of state from liquid to gas as the temperature increases above a transition temperature. For example, as the temperature of chips 14G and 14H (FIG. 2) increases during operation, coolant in the vicinity of the fins 51A on chips 14G and 14H becomes warmer and micropoints of liquid touching the surface of the fins 51A and the chips 14G and 14H change state to a gas. This change of state from liquid to gas augments the specific heat of the coolant and makes the coolant a more effective heat absorber. As the coolant absorbs heat during this change of state, the chips 14G and 14H are cooled.

During the change in state, bubbles 52 are formed at the fins 51A and the chips 14G and 14H. Since these bubbles 52 are lighter than the liquid coolant, the bubbles 52 move to the top of the chamber 40. The bubbles 52 rise until they engage the fins 38. Upon engagement with the fins 38, heat from the bubbles 52 is transferred to the fins 38 and the coolant returns to a liquid state.

To dissipate heat from the fins 38, a heat exchanger 54 can be mounted to the top 36 of the housing 24. The heat exchanger 54 can be a separate unit that is attached to the housing 24, or it may be an integral component of the housing 24. In the preferred embodiment illustrated, the heat exchanger 54 is similar to a duct with sides 56 and 58, a top 60 and a bottom 62 leaving open ends 64. The duct formed by the sides 56 and 58, top 60 and bottom 62 may be connected to a source of coolant for the flow of coolant, which may be water, air or a refrigerant, through the heat exchanger 54. The coolant flowing through the heat exchanger 54 cools the fins 38 and the top 36 helping to dissipate heat from the coolant in chamber 40.

The heat exchanger 54 is slightly larger than the housing 24 providing an overhang. Apertures 66 are formed in each corner of the top 60 and bottom 62 of the heat exchanger 54 through which the fasteners 42 extend. By threading the fasteners 42 into the apertures 44 in the multichip unit 12, the housing 24 and heat exchanger 54 are attached as an integral unit to the multichip unit 12, and the interface at the lower edge 28 of the housing 24 is sealed against the sealing track 26 to prevent leakage of coolant.

The independent cooling system 10 of the present invention allows the chips 14A-H to be mounted densely on the multichip unit 12 with short interconnecting leads to provide maximum performance of the multichip unit 12. Since the cooling system 10 is independent or portable in the sense that it is not permanently connected to the entire cooling system for the computer or electronic device in which the multichip unit 12 is installed, the cooling system 10 may be shut down, disassembled and the chips 14A-H tested or replaced without interference with the rest of the cooling system. The portable means of attaching the independent cooling system 10 to the multichip unit 12 allows technicians to test and repair the multichip unit 12 without having to handle possibly toxic coolant thereby providing a safe working environment.

The foregoing is considered as illustrative only of the principles of the invention. Since numerous modifications and changes will readily occur to those skilled in the art, it is not desired to limit the invention to the exact construction and operation shown and described and accordingly, all suitable modifications and equivalents may be restored to that fall within the scope of the invention as claimed.

## Claims

1. An independent heat extraction device for semiconductor chips in a multichip unit, comprising:

   a heat extraction housing for at least one semiconductor chip on a multichip unit;

   a first chamber in said heat extraction housing;

   means for mounting said heat extraction housing on said multichip unit to position said at least one semiconductor chip in at least a portion of said housing; and

   a first coolant in said first chamber and in contact with at least one semiconductor chip for extraction of heat.

2. The independent heat extraction device set forth in claim 1 wherein said first coolant is a fluorocarbon.

3. The independent heat extraction device set forth in claim 1 wherein said first coolant is air.

4. The independent heat extraction device set forth in claim 1 further comprising a heat exchanger on said heat extraction housing.

5. The independent heat extraction device set forth in claim 4 wherein said heat exchanger includes a second chamber in said heat extraction housing in heat transfer relationship to said first chamber, a second coolant in said second chamber.

6. The independent heat extraction device set forth in claim 1 further comprising means for sealing an interface between said heat extraction housing and said multichip unit upon mounting said heat extraction housing onto said multichip unit.

7. The independent heat extraction device set forth in claim 1 wherein said mounting means includes an opening in said first chamber of substantially the same configuration as said at least one semiconductor chip.

8. The combination comprising:

a multichip unit including at least one semiconductor chip; and

an independent cooling chamber for cooling said at least one semiconductor chip, said independent cooling chamber including a housing with a first chamber, said first chamber configured to cover at least said at least one semiconductor chip, a first coolant in said first chamber, and

means for sealing an interface between said multichip unit and said housing of said independent cooling chamber upon mounting said housing on said multichip unit.

9. The combination claimed in claim 8 wherein said first coolant is a fluorocarbon.

10. The combination claimed in claim 8 wherein said first coolant is air.

11. The combination claimed in claim 8 further comprising a heat exchanger for dissipating heat from said first chamber, said heat exchanger including a second chamber, a second coolant in said second chamber.

12. The combination claimed in claim 11 wherein said second coolant is a fluorocarbon.

13. The combination claimed in claim 11 wherein said second coolant is air.

14. The combination claimed in claim 8 wherein said sealing means includes a sealing element mounted in said multichip unit and surrounding said at least one semiconductor chip.

15. The combination claimed in claim 8 further comprising an extended surface on said at least one semiconductor chip, said extended surface being at least partially in said independent cooling chamber.

16. A method of cooling semiconductor chips in a multichip unit comprising the steps of:

placing an open ended housing over at least one semiconductor chip of a multichip unit;

securing said open ended housing to said multichip unit to define a first chamber with said at least one semiconductor chip in said first chamber; and

introducing a first coolant into said first chamber in contact with said at least one semiconductor chip.

17. The method of cooling semiconductor chips in a multichip unit claimed in claim 16 further comprising the step of exchanging heat from said first coolant to a second coolant.

18. The method for cooling at least one chip of a multichip unit set forth in claim 16 further comprising the step of sealing an interface between said first chamber and said multicomponent device.

19. A method of cooling selected chips of a multichip unit comprising the steps of

isolating selected chips from other chips on a multichip unit, and

exposing the isolated selected chips to a first coolant.

20. The method of cooling selected chips of a multichip unit set forth in claim 19 wherein said step of isolating selected chips includes securing a housing onto said multichip unit to enclose said selected chips in said housing.

21. The method of cooling selected chips of a multichip unit assembly set forth in claim 19 further comprising the step of transferring heat from said first coolant to a second coolant.

FIG.1

FIG.2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | WO-A-8 810 511 (NCR)<br>* figures 1-4; page 3, line 23 - page 6, line 16 *<br>– – – | 1,4-6,8,<br>11,14-21 | H 05 K 7/20<br>H 01 L 23/427<br>H 01 L 23/44 |
| A | IBM TECHNICAL DISCLOSURE BULLETIN vol. 32, no. 5A, October 1989, pages 153-154, New York, US; "Means of removing more heat from a TCM by reducing coolant temperature"<br>* complete document *<br>– – – | 1,2,4-6,8,<br>9,11,12,<br>14-18 | |
| A | EP-A-0 009 605 (IBM)<br>* figures 1-3; page 3, line 27 - page 6, line 29 *<br>– – – | 1,4-6,8,<br>11,14-18 | |
| A | EP-A-0 200 221 (FUJITSU)<br>* figures 2-4,7-10; claims 1-3,8,9 *<br>– – – | 1,4,5,6,8,<br>11,16-18 | |
| A | US-A-3 851 221 (BEAULIEU et al.)<br>* figures 1,5; column 1, line 42 - column 6, line 38 *<br>– – – – – | 1,2,4,6,8,<br>9,11,13,<br>14,16-18 | |

TECHNICAL FIELDS
SEARCHED (Int. Cl.5)

H 05 K 7/20
H 01 L 23/40

The present search report has been drawn up for all claims

| Place of search | Date of completion of search | Examiner |
|---|---|---|
| Berlin | 18 December 90 | HAHN G |